# EUROPÄISCHE PATENTSCHRIFT

(11) **EP 4 161 804 B1**
(45) Veröffentlichungstag und Bekanntmachung des Hinweises auf die Patenterteilung: **21.08.2024**
(21) Anmeldenummer: 21728869.5
(22) Anmeldetag: 21.05.2021
(51) Int. Cl.: H01L 23/055, H01L 23/24, B81B 7/00, H05K 7/12

(54) **VIBRATIONSROBUSTE ELEKTRONIKKOMPONENTE**
VIBRATION-RESISTANT ELECTRONIC COMPONENT
COMPOSANT ÉLECTRONIQUE RÉSISTANT AUX VIBRATIONS

(30) Priorität: 05.06.2020 DE 102020115066
(43) Veröffentlichungstag der Anmeldung: 12.04.2023
(73) Patentinhaber: Pollmann International GmbH, 3822 Karlstein (AT)
(72) Erfinder: HUNZIKER, Urs, 8706 Meilen (CH); RAMETSTEINER, Karl, 4040 Linz (AT); SCHMIDT, Roman, 3813 Dietmanns (AT); DORR, Alexander, 3822 Karlstein an der Thaya (AT); GREULBERGER, Andreas, 3820 Raabs an der Thaya (AT)
(74) Vertreter: Dilg, Haeusler, Schindelmann Patentanwaltsgesellschaft mbH
(86) Internationale Anmeldenummer: PCT/EP2021/063701
(87) Internationale Veröffentlichungsnummer: WO 2021/244882

(56) Entgegenhaltungen:
- EP-A2- 2 040 526
- DE-A1- 102013 201 424
- DE-A1- 102017 009 550
- US-A1- 2005 057 902

## Beschreibung

### Technisches Gebiet

Die vorliegende Erfindung betrifft eine Vorrichtung zum vibrationssicheren Einhausen einer elektronischen Komponente und ein entsprechendes Herstellverfahren.

### Hintergrund der Erfindung

In einem vibrationsbelasteten Umfeld, wie z. B. dem Automotive-Bereich, sind vibrationsinduzierte Resonanzprobleme bei elektronischen Komponenten möglich. Insbesondere bei elektronischen Komponenten, welche in einem Spritzgussteil eingebaut sind und mit einer relativ steifen Vergussmasse zur Erreichung einer Festmontage und einer IP 67 Dichtheit vergossen sind, besteht die Gefahr störende Vibrationen zu übertragen. Dabei stellen sich funktionelle (z.B. Schaltpunktverschiebung bei Schaltern), akustische (hörbare Vibrationen) und vor allem Langzeitzuverlässigkeitsprobleme bei der Verbindungsstelle zwischen der elektronischen Komponente und Umgebung ein.

Das Dokument EP 2 040 526 A2 offenbart eine Vorrichtung zum vibrationssicheren Einhausen einer elektronischen Komponente unter Verwendung einer Dämpfungsschicht, offenbart aber weder ein faserverstärktes Trägerelement noch eine zusätzliche Füllmasse, und des Weiteren auch keine Kavität des Trägerelements zum Aufnehmen der Kavität, noch besteht die Dämpfungsschicht aus thermoplastischem Elastomer.

Das Dokument DE 10 2013 201424 A1 offenbart eine Vorrichtung zum vibrationssicheren Einhausen einer elektronischen Komponente unter Verwendung einer Dämpfungsschicht, offenbart aber weder ein faserverstärktes Trägerelement noch eine zusätzliche Füllmasse, und des Weiteren auch nicht die genaue Anordnung der Dämpfungsschicht und auch nicht die Kopplung des elektrischen Leiters mit dem Trägerelement.

Das Dokument US 2005/057902 A1 offenbart eine Vorrichtung zum vibrationssicheren Einhausen einer elektronischen Komponente unter Verwendung einer Dämpfungsschicht, offenbart aber weder ein faserverstärktes Trägerelement noch eine zusätzliche Füllmasse, und des Weiteren auch keine Kavität des Trägerelements zum Aufnehmen der Kavität, noch die genaue Anordnung der Dämpfungsschicht.

Das Dokument DE 10 2017 009550 A1 offenbart eine Vorrichtung zum stoßbelastungssicheren Einhausen einer elektronischen Komponente unter Verwendung einer Dämpfungsschicht, offenbart aber weder ein faserverstärktes Trägerelement noch eine zusätzliche Füllmasse, und des Weiteren auch nicht die genaue Anordnung der Dämpfungsschicht.

### Darstellung der Erfindung

Es ist eine Aufgabe der vorliegenden Erfindung, eine elektronische Komponente vibrationssicher einzuhausen.

Diese Aufgabe wird mit einer Vorrichtung zum vibrationssicheren Einhausen einer elektronischen Komponente und einem Verfahren zum Herstellen einer solchen Vorrichtung gemäß den Gegenständen der unabhängigen Ansprüche 1 und 13 gelöst.

Gemäß einem ersten Aspekt der Erfindung wird eine Vorrichtung zum vibrationssicheren Einhausen einer elektronischen Komponente beschrieben. Die Vorrichtung weist ein faserverstärktes, spritzgegossenes Trägerelement auf, welches eine Kavität zum Aufnehmen der elektronischen Komponente aufweist. Ferner weist die Vorrichtung die elektronische Komponente, welche in der Kavität angeordnet ist, und eine Dämpfungsschicht, welche direkt auf dem Trägerelement aufgebracht ist und zumindest bereichsweise zwischen der elektronischen Komponente und dem Trägerelement angeordnet ist, auf. Die Dämpfungsschicht weist ein Material aus thermoplastischem Elastomer auf. Eine Dicke zwischen der elektronischen Komponente und dem Trägerelement beträgt mindestens 100 µm (Mikrometer).

Die Vorrichtung weist ferner eine Füllmasse auf, welche an der Dämpfungsschicht und der elektronischen Komponente anhaftet und zwischen der elektronischen Komponente und dem Trägerelement angeordnet ist. Zudem ist ein elektrischer Leiter vorgesehen, welcher mit der elektronischen Komponente und dem Trägerelement gekoppelt ist und zumindest bereichsweise von der Dämpfungsschicht umgeben ist.

Ferner wird gemäß einem weiteren Aspekt der vorliegenden Erfindung ein Verfahren zum Herstellen einer oben beschriebenen Vorrichtung beschrieben. Die elektronischen Komponenten können beispielsweise Mikroschalter, Drahtwiderstände, MEM's (Micro-Electro-Mechanical Systems) oder integrierte Schaltkreise (IC, mit SMD oder DIL Anschlüssen) sein. Unter dem Begriff "elektronischer Komponente" werden auch elektrische Komponenten, wie beispielsweise Schmelzsicherungen und dergleichen, verstanden. In der Vorrichtung wird eine elektronische Komponente in eine entsprechende Kavität des Trägerelements eingesetzt. Ferner können mehrere elektronische Komponenten in eine entsprechende Kavität des Trägerelements eingesetzt werden oder das Trägerelement kann mehrere Kavitäten aufweisen, in welchen jeweils eine elektronische Komponente einsetzbar ist.

Die elektronische Komponente weist ferner einen elektrischen Leiter auf, welcher zur Energieübertragung oder Signalübertragung insbesondere an die Umgebung dienen kann. Die elektrischen Leiter sind häufig starr angebaute elektrische Verbindungen aus Massivleitern. Gerade bei Lötverbindungen zwischen dem elektrischen Leiter und einem Verbindungspartner kann eine mechanische Vibrationsbelastung zu einem Schwingbruch führen. Mit dem Begriff "elektronische Komponenten" werden zusammenfassend verschiedene elektrische, elektromechanische oder elektronische Komponenten verstanden, die in dem Trägerelement, welches als Spritzgussgehäuse ausgebildet ist, eingebettet sind. Insbesondere sind die elektronischen Komponenten zur Kontaktierung mit massivleiterbasierenden Verbindungen ausgebildet, welche mit entsprechenden Leitern im Trägerelement elektrisch leitend gekoppelt werden können.

Das Trägerelement ist ein faserverstärktes, spritzgegossenes Bauteil, welches über eine ausreichende Festigkeit und Härte verfügt. Das Trägerelement weist die Kavität auf, in welcher die elektronische Komponente (oder in einer beispielhaften Ausführungsform mehrere elektronische Komponenten) eingebettet werden. Das Trägerelement und dessen Kavität können dabei derart ausgebildet sein, dass zumindest zwei Seiten einer elektronischen Komponente abgedeckt werden können. So kann beispielsweise eine Kavität mittels eines V- förmigen oder L- förmigen Trägerelements gebildet werden. Die Kavität kann ferner derart ausgebildet werden, dass zumindest eine Seite der Komponente frei bleibt und nicht von einem Bereich des Trägerelements abgedeckt wird. In einer weiteren beispielhaften Ausführungsform kann die Kavität eine Öffnung aufweisen, in welcher die elektronische Komponente eingeführt werden kann, wobei diese Öffnung im Anschluss durch ein Abdeckelement verschlossen wird.

Das Trägerelement ist faserverstärkt, um eine hohe Festigkeit zu gewährleisten. Dabei können Faserverstärkungsmaterialien eingesetzt werden, die eingebettet in eine Polymermatrix einen Faserverbundstoff ergeben.

Die Füllmasse (Vergussmasse) umhüllt zumindest teilweise die elektronische Komponente und bildet eine Befestigung der elektronischen Komponente in der Kavität des Trägerelements. Als Vergussmasse können insbesondere giessbare Kunststoffe auf PUR (Polyurethan) oder Epoxidbasis eingesetzt werden. Die Füllmasse haftet an der elektronischen Komponente an und ist zwischen der elektronischen Komponente und dem Trägerelement angeordnet, um die elektronische Komponente entsprechend zu befestigen. Ferner ist die Füllmasse zumindest in einem Teilbereich an der Dämpfungsschicht anhaftend. Dadurch kann die Dämpfungsschicht Vibrationen der insbesondere steiferen Füllmasse aufnehmen.

Die Dämpfungsschicht besteht aus einem thermoplastischen Elastomer (TPE). Das Elastomer weist eine Shore-Härte von 35 bis 55 Shore A auf. Besonders gute Ergebnisse wurden im Shore-Härtebereich von 40 bis 45 Shore A erreicht. Die Dämpfungsschicht verhält sich insbesondere bei Raumtemperatur vergleichbar mit klassischen Elastomeren. Unter Wärmezufuhr verformt sich die Dämpfungsschicht plastisch und zeigt somit ein thermoplastisches Verhalten. Die Dämpfungsschicht besteht beispielsweise aus den TPE-Materialien Thermoflex40HH800, Thermoflex A5, oder Thermoflex S3005/212.

Die Füllmasse ist neben der Anhaftung an der elektronischen Komponente ebenfalls an der Dämpfungsschicht anhaftend, sodass die Dämpfungsschicht Vibrationen, welche von der elektronischen Komponente auf die Füllmasse übertragen werden, aufnehmen kann. Zudem ist die Dämpfungsschicht direkt auf dem Trägerelement aufgebracht, sodass ebenfalls Vibrationen, welche von dem Trägerelement auf die Dämpfungsschicht übertragen werden, gedämpft werden können.

Aufgrund der Materialeigenschaften der Dämpfungsschicht als thermoplastisches Elastomer haftet die Dämpfungsschicht deutlich besser an dem faserverstärkten Trägerelement als die Füllmasse. Gleichzeitig haftet die Füllmasse besser an dem thermoplastischen Elastomer als an dem faserverstärkten Trägerelement. Somit dient das thermoplastische Elastomer neben der Vibrationsdämpfung zudem als Haftvermittler zwischen der elektronischen Komponente, der Füllmasse und dem Trägerelement.

Dabei hat sich im Rahmen der Erfindung herausgestellt, dass be einer Dicke der Dämpfungsschicht in einem Bereich zwischen der elektronischen Komponente und dem Trägerelement von über 100 µm eine gute Dämpfungseigenschaft bei gleichzeitiger vorteilhafter Haftung der Dämpfungsschicht bereitgestellt werden kann. Somit wird das Risiko einer Ablösung der entsprechenden Schichten voneinander reduziert und gleichzeitig die Dämpfungseigenschaft gegenüber Vibrationen erhöht.

Diese Wirkung wird dadurch verstärkt, dass der elektrische Leiter zumindest bereichsweise von der Dämpfungsschicht umgeben ist. Dabei kann die Dämpfungsschicht den elektrischen Leiter direkt kontaktieren und sich um den elektrischen Leiter anschmiegen oder den elektrischen Leiter beabstandet, d. h. mit einem kleinen Abstand bzw. Spalt, umgeben. Dabei wird die Vibrationsübertragung auf den elektrischen Leiter reduziert, sodass das Risiko eines Abrisses des Leiters von den entsprechenden Kontaktpartnern reduziert wird.

Zusammenfassend wird gemäß der vorliegenden Erfindung Materialien unterschiedlicher Eigenresonanzfrequenzen derart kombiniert, dass es damit möglich ist, das Schwingungsverhalten einer, in einem Spritzgussteil bzw. in dem Trägerelement eingebetteten elektronischen Komponente derart zu steuern, dass keine Langzeitveränderungen der elektrischen Verbindungsqualität bei massivleiterbasierenden lötfreien Verbindungen zwischen Komponente und Umgebung entstehen.

Es wurde ferner herausgefunden, dass durch die Aufbringung eines Zwischenmaterials, d. h. der Dämpfungsschicht, welche ein unterschiedliches Elastizitätsmodul im Vergleich zur Füllmasse aufweist, zwischen dem Trägerelement und der Füllmasse, ein duales System mit unterschiedlichen Eigenresonanzfrequenzen bereitgestellt wird. Dadurch ergibt sich die Situation, dass über den ganzen Frequenzbereich einer typischen Anwendung (beispielsweise im Automotivbereich) keine ausgeprägte Eigenresonanzfrequenz (mit deren störenden Selbstresonanz und den damit verbundenen Kontaktalterungsproblemen) mehr vorhanden ist. Die jeweils andere Schicht (entweder Zwischenmaterial oder Vergussmasse) hat eine andere Eigenresonanzfrequenz und wirkt dadurch schwingungsdämpfend. Es wurde gefunden, dass sich thermoplastisches Elastomer besonders gut als ein solches Zwischenmaterial eignet, weil erstens seine Elastizität in weiten Bereichen eingestellt werden kann und andererseits damit auch eine gute Haftung sowohl zum Spritzgussaussenteil (Trägerelement), als auch zur Füllmasse erreicht wird.

Es wurde ferner erkannt, dass sowohl durch Variation und gezielte Selektion der Elastizitäten der Dämpfungsschicht und der Füllmasse, als auch die Wahl der mittleren Dicke von der thermoplastischen Dämpfungsschicht und der Füllmasse zwei orthogonale (im Sinne von gegenseitig unabhängig) Einstellmechanismen zur Verfügung stehen, so dass zusätzliche Anforderungen von z.B. Elastizität der thermoplastischen Dämpfungsschicht zur Dichtungsoptimierung an einer anderen Stelle des Spritzgussteils berücksichtigt werden können, ohne gleichzeitig die Schwingungseinstellung zu beeinträchtigen. Die Einstellung der Dicke der thermoplastischen Dämpfungsschicht kann in einem Spritzgussvorgang umgesetzt werden. Die Anwendung der Beschichtungsdicke der Dämpfungsschicht bildet somit unterschiedliche Eigenresonanzfrequenzen zu den anderen Komponenten, insbesondere zu der Füllmasse, sodass eine Dämpfungswirkung erzielbar ist.

Diese erfindungsgemäße Lösung führt zu einer langfristig sehr guten elektrischen Verbindung für die in das Spritzgussteil (Trägerelement) eingebaute Elektro- oder Elektronikkomponente. Insbesondere wird dadurch das Risiko von oxydationsrelevantem Aufreißen von Kaltverschweißungen bei druckbasierenden Verbindungsmechanismen reduziert.

Insbesondere ergibt sich erfindungsgemäß für die Verbauung von Schaltern (z.B. Microswitches) der zusätzliche Vorteil einer besonders guten mechanischen Schaltschwelle. Damit sind Positionierungswiederholgenauigkeiten von weniger als 1 mm, insbesondere von weniger als 100 Mikrometern oder sogar von weniger als 10 Mikrometern möglich, insbesondere innerhalb des ganzen Vibrationsbereiches, wie er zum Beispiel im Automotivbereich üblich ist.

Gemäß einer weiteren beispielhaften Ausführungsform ist die Füllmasse zumindest in einem Dämpfungsbereich zwischen der Dämpfungsschicht und der elektronischen Komponente angeordnet. Der Dämpfungsbereich kann sich bereichsweise oder vollständig zwischen der elektronischen Komponente und dem Trägerelement befinden. In der beispielhaften Ausführungsform liegt direkt am Trägerelement eine erste Oberfläche der Dämpfungsschicht an. An der gegenüberliegenden zweiten Oberfläche der Dämpfungsschicht liegt beispielsweise direkt die Füllmasse an. Die Füllmasse erstreckt sich von der zweiten Oberfläche bis zu der elektronischen Komponente. Der elektrische Leiter kann zwischen dem Trägerelement und der elektronischen Komponente verlaufen und entsprechend ausgehen von der elektronischen Komponente zunächst durch die Füllmasse und weiter durch die Dämpfungsschicht zum Trägerelement verlaufen.

Gemäß einer weiteren beispielhaften Ausführungsform ist die Dämpfungsschicht in einem Dämpfungsbereich in direktem Kontakt mit dem Trägerelement und der elektronischen Komponente. Mit anderen Worten wird in einen Volumenbereich zwischen der elektronischen Komponente und des Trägerelements ein Dämpfungsbereich gebildet, in welchen die Dämpfungsschicht direkt zwischen dem Trägerelement und der elektronischen Komponente verläuft. Mit anderen Worten ist in dem Dämpfungsbereich die Dämpfungsschicht in direkten Kontakt mit dem Trägerelement und der elektronischen Komponente. Der elektrische Leiter läuft in dieser beispielhaften Ausführungsform zwischen dem Trägerelement und der elektronischen Komponente vollständig innerhalb Dämpfungsschicht. Der elektrische Leiter kann dabei in direkten Kontakt mit der Dämpfungsschicht stehen oder beabstandet, beispielsweise durch ein weiteres Trennmaterial, innerhalb der Dämpfungsschicht verlaufen.

Gemäß einer weiteren beispielhaften Ausführungsform unterscheidet sich das E-Modul der Dämpfungsschicht von dem E-Modul der Füllmasse. Insbesondere ist das E-Modul der Dämpfungsschicht kleiner als das E-Modul der Füllmasse. Insbesondere die unterschiedlichen E-Module zwischen der Dämpfungsschicht und der Füllmasse führen zu unterschiedlichen Eigenfrequenzen zwischen der Dämpfungsschicht und der Füllmasse, wodurch wiederum die Dämpfungswirkung zwischen den beiden Materialkomponenten verstärkt wird.

Gemäß einer weiteren beispielhaften Ausführungsform weist die Dämpfungsschicht zwischen der elektronischen Komponente und dem Trägerelement eine Dicke zwischen 0,5 mm und 5 mm auf. Es hat sich herausgestellt, dass insbesondere in dem beschriebenen Dickenbereich einerseits eine hohe Festigkeit und andererseits eine gute Dämpfungswirkung erzielt wird.

In einer beispielhaften Ausführungsform liegt das Verhältnis einer mittleren Dicke in einem Dickenbereich zwischen einer mittleren Dicke der Dämpfungsschicht und einer mittleren Dicke der Füllmasse beispielsweise 1:20 bis 20:1, insbesondere 1:10 bis 10:1. Die Dämpfungsschicht und die Füllmasse können zwischen der elektronischen Komponente und dem Trägerelement unterschiedliche Dicken aufweisen, wobei die Dicke der Dämpfungsschicht jedoch immer über 100 µm aufweisen soll. In einer besonderen Ausführungsform ist das Verhältnis einer mittleren Dicke in einem Dickenbereich der Dämpfungsschicht und einer mittleren Dicke in einem Dickenbereich der Füllmasse beispielsweise 1:1 bis 1:100, insbesondere 1:10 bis 1:25.

Der Dickenbereich ist entsprechend in dem Dämpfungsbereich definiert, in welchem die Füllmasse und die Dämpfungsschicht vorliegt und in welchem der kürzeste Abstand der Dämpfungsschicht zwischen einem Bodenbereich oder Seitenbereich des Trägerelements zur elektronischen Komponente vorliegt. In einem Dickenbereich kann die Dicke der Dämpfungsschicht variieren, wobei aus den verschiedenen Dicken im Dickenbereich eine mittlere Dicke gebildet werden kann.

Gemäß einer weiteren beispielhaften Ausführungsform ist die Dämpfungsschicht mittels einer stofflichen Verbindung an dem Trägerelement, der Füllmasse und/oder an der elektronischen Komponente befestigt. Die Dämpfungsschicht, welche aus thermoplastischen Elastomeren besteht, hat insbesondere bessere Hafteigenschaften als die Füllmasse. Insbesondere haftet die Dämpfungsschicht besser an dem Trägerelement als typische Materialien der Füllmasse, wie beispielsweise Epoxide und andere Kunstharze.

Somit fungiert die Dämpfungsschicht neben ihrer Eigenschaft zur Dämpfung ebenfalls als Haftvermittler, da die Dämpfungsschicht besser an dem Trägerelement anhaften kann als die Füllmasse.

Gemäß einer weiteren beispielhaften Ausführungsform weist die Dämpfungsschicht eine Kontaktfläche zu der Füllmasse auf, wobei die Kontaktfläche strukturiert ist und insbesondere eine wellenförmige Oberfläche und/oder eine geriffelte Oberfläche aufweist. Dadurch wird insbesondere die Kontaktoberfläche zwischen der Füllmasse und der Dämpfungsschicht sowie beispielsweise die Rauigkeit erhöht. Dies führt zu einer stärkeren Verbindung zwischen der Dämpfungsschicht zu der Füllmasse auf. Eine entsprechende strukturierte Oberfläche kann ebenfalls auf der Oberfläche der Dämpfungsschicht vorgesehen werden, welche mit dem Trägerelement verbunden wird.

Mittels der Strukturierung der TPE-Schicht zur Vergussmasse hin entsteht ein mechanischer Rückhalt. Dies kann durch zum Beispiel eine Oberflächenstrukturierung (gewellt, geriffelt, rau, usw.), einen saumartigen Rand, Klammern, Bügel, Profile usw. realisiert werden. Insbesondere können solche Strukturen derart ausgestaltet sein, dass dennoch die Ausformung aus der Spritgussmaschinenform problemlos möglich ist. Insbesondere gilt:
a) durch die Elastizität der Dämpfungsschicht aus TPE sind Form-Hinterschneidungen mit diesem Material, im Gegensatz zu harten Polymeren sehr gut möglich. Hilfreich ist, dass die Haftung ausreicht und genügend abgekühlt ist, daher werden auch gute Ergebnisse mit einer geringen TPE-Schichtstärke zwischen Faserteil und Vergussmasse erreicht.
b) Insbesondere verhindert die gute Haftung zwischen der Dämpfungsschicht aus TPE und Vergussmasse ein Eindringen von Feuchtigkeit und erlaubt so den langfristigen Schutz vor eindringender Feuchtigkeit und die Realisierung einer hohen Drucksicherheit.
c) Bildet die Oberflächenstrukturierung Hinterschneidungen, kann auch die Positionierung der elektronischen Komponenten vor dem Verguss optimal verbessert werden. Die Druckelastizität der Dämpfungsschicht aus TPE hält die elektronische Komponente unter Klemm-Spannung, was wiederum eine zusätzliche Vibrationsstabilität ergibt.

Gemäß einer weiteren beispielhaften Ausführungsform weist die Dämpfungsschicht einen Vergussbügel auf, insbesondere aufweisend eine Klammerform, welcher in die Füllmasse ragt. Der Vergussbügel ragt entsprechend von der Dämpfungsschicht in die Füllmasse hinein. Der Vergussbügel besteht beispielsweise aus demselben Material wie die Dämpfungsschicht und kann beispielsweise zusammen in einem Spritzgussverfahren hergestellt werden. Die Füllmasse kann in einem Gießvorgang um den Vergussbügel gegossen werden, sodass nach der Aushärtung eine gute mechanische Befestigung vorliegt.

Ein entsprechender Vergussbügel kann ebenfalls von dem Trägerelement in die Füllmasse hineinragen und entsprechend eine mechanische Befestigung zwischen der Füllmasse und dem Trägerelement verbessern.

Gemäß einer weiteren beispielhaften Ausführungsform weist die Kavität des Trägerelements eine Öffnung auf, durch welche die elektronische Komponente mit einem hervorragenden Bereich in die Umgebung ragt. Zwischen dem hervorragenden Bereich und dem Trägerelement liegt zumindest ein Bereich der Dämpfungsschicht und/oder dem Füllmaterial derart vor, dass ein Innenbereich der Vorrichtung flüssigkeitsdichtend von einer Umgebung der Vorrichtung abgedichtet ist. Somit wird in einem Abstandsbereich zwischen dem Trägerelement und der elektronischen Komponente, in welchem Abstandsbereich eine Öffnung zur Umgebung vorliegt, das Abdichten mittels dem Füllmaterial und/oder der Dämpfungsschicht vorgesehen, so dass eine Abdichtung, insbesondere gegenüber Flüssigkeiten, zwischen dem weiteren Innenvolumen der Vorrichtung und der Umgebung bereitgestellt wird. Eine Abdichtung mittels eines direkten Kontakts zwischen dem Trägerelement und der elektronischen Komponente ist oftmals nur schwer zu erreichen. Eine Füllung in diesem Abstandsbereich mit der Füllmasse und/oder der Dämpfungsschicht erhöht die Dichtwirkung. Dadurch wird insbesondere eine Wasserdichtheit nach IP 67 ermöglicht.

Gemäß einer weiteren beispielhaften Ausführungsform weist das Trägerelement zumindest ein Positionselement auf, an welchem die elektronische Komponente anliegt und positionierbar ist. Das Positionselement ist beispielsweise ein Steg oder eine Kante bzw. Stufe, um einen Sitz bzw. eine Auflage für die elektronische Komponente zu bilden. Das Positionselement ist beispielsweise integral mit dem Trägerelement ausgebildet und kann in einem gemeinsamen Spritzgussverfahren hergestellt werden. In einer beispielhaften Ausführungsform ist das Positionselement ein Führungszapfen, eine Führungsschiene oder eine Führungsbahn, an welchem ein korrespondierendes Koppelelement (d. h. beispielsweise ein Gehäuseteil) des elektronischen Bauteils koppelbar ist.

Die elektronische Komponente kann durch den mechanischen Aufbau ihrer Außengeometrie einerseits gehalten und andererseits der Kontaktierung positionsgenau zugeführt werden. Dies kann durch die Ausgestaltung der Außengeometrie oder das Positionselement, z.B. durch zusätzliche Führungszapfen, -schienen und/oder -bahnen realisiert werden. Durch eine geeignete Ausgestaltung dieser Zusatzfunktionalität, d.h. beispielsweise der Positionselemente, in Bezug auf Schwingungsübertragung (Richtung, Eigenresonanzfrequenz, usw.) kann das Risiko von störenden Vibrationen reduziert oder verhindert werden. Im Gegensatz zur mechanischen Festigkeit des Spritgussteils bzw. Trägerelements nach Außen (was eine massivere Ausgestaltung verlangt) kann ein solches Führungssystem an Positionselementen filigran ausgestaltet werden und so die Vibrationsauswirkungen entweder gesteuert oder generell minimiert werden. Gemäß einer weiteren beispielhaften Ausführungsform weist das Trägerelement Polypropylen (PP, z.B. Thermofil HPF610X99) und/oder Polybutylenterephthalat (PBT, z.B. Ultradur S4090G4) auf.

Gemäß einer weiteren beispielhaften Ausführungsform weist das Trägerelement einen Faseranteil in Gewichtsprozent zwischen 5% und 60%, insbesondere zwischen 10% und 50 %, und weiter insbesondere zwischen 15% und 40% aufweist.

Durch die erfindungsgemäße Vibrationsdämpfung mittels der Dämpfungsschicht kann auch ein Spritzgussteil als Trägerelement mit besonders hohem Faseranteil realisiert werden. Im Normalfall leiten Fasern Vibrationen in Längsrichtung besonders gut. Wenn beim Spritzgießen eine Faser-Kunststoffschmelze in ein längliches Spritzgussteil eingespritzt wird, erfolgt vom Einspritzpunkt weg eine Ausrichtung der Fasern in eben dieser Längsrichtung, was das Problem der Vibrationsweiterleitung zusätzlich verstärkt. Durch die erfindungsgemäße Schwingungsdämpfung lässt sich so ein besonders hoher Faseranteil erreichen, ohne schädliche Vibrationen zu generieren.

Gemäß einer weiteren beispielhaften Ausführungsform weist das Trägerelement Verstärkungsfasern auf bestehend aus Mineralfasern, insbesondere Silikate, Glas, Basalt, Asbest, Wollastonit, Carbonfasern, insbesondere Kohlenstoffnanoröhren, Polymerfasern, insbesondere Polyamidfaser, Polyimidfasern, Polyester, Polyolefine, Polyesteramide, Aramide, insebsondere Kevlar und/oder Naturfasern, insbesondere Cellulose, Baumwolle, Viskose, Lyocell, Holz, Hanf, Seide.

Gemäß einer weiteren beispielhaften Ausführungsform weisen die Verstärkungsfasern Langfasern mit einer Länge von 1 mm bis 20mm, insbesondere von 5mm bis 15 mm, auf.

Gemäß einer weiteren beispielhaften Ausführungsform weist die Füllmasse Polyurethan oder Epoxidharz auf, beispielsweise Fermadur A & B.

Gemäß einer weiteren beispielhaften Ausführungsform ist der elektrische Leiter ein Massivleiter, wobei der Massivleiter insbesondere einen Querschnitt von 0,1mm² bis 10 mm²aufweist. Ein Massivleiter besteht insbesondere aus einem (monolithischen) Volldraht oder Vollblech. Insbesondere unterscheidet sich ein Massivleiter von dickeren Litzen (welche jeweils aus mehreren Einzelleitern gebildet werden) insbesondere mit einem Querschnitt von mehr als 16 mm².

Massivleiter bilden eine hohe Stabilität und eine gute Leitfähigkeit aus. Es entsteht mit einem Massivleiter aber auch ein besonders starkes Doppelschwingungssystem. Aufgrund der erfindungsgemäßen Dämpfungsschicht werden diese auf dem Massivleiter basierenden Schwingungen gedämpft werden.

Gemäß einer weiteren beispielhaften Ausführungsform verläuft der elektrische Leiter zum externen Anschluss von der elektronischen Komponente durch das Trägerelement, wobei der elektrische Leiter mit der elektronischen Komponente mittels Lötens, Schweißens, Steckens insbesondere einer Schneidklemmverbindung und/ oder Klemmens elektronisch gekoppelt ist.

Gemäß einer weiteren beispielhaften Ausführungsform ist die elektronische Komponente ein Mikroschalter, ein Aktor, ein Widerstand oder ein Sensor, insbesondere ein Temperatursensor oder ein Abstandsschalter ist.

Insbesondere Mikroswitches mit einer besonders kleinen mechanischen Hysterese können mittels der vorliegenden Erfindung verbaut. Durch die erfindungsgemäße Vibrationsunempfindlichkeit können Mikroswitches mit einer Hysterese von kleiner als 1 mm, insbesondere kleiner als 200 Mikrometern, und bei Mikroswitches besonders guter Qualität mit einer Hysterese von kleiner als 50 Mikrometer ohne Fehlschaltungen bei Vibrationen, insbesondere automotivtypischen Vibrationen, erreicht werden.

Gemäß einer weiteren beispielhaften Ausführungsform des Verfahrens wird die Dämpfungsschicht mittels eines Spritzgußverfahrens, insbesondere mittels eines 2-Komponenten Spritzgussverfahrens, auf das Trägerelement aufgebracht.

Gemäß einer weiteren beispielhaften Ausführungsform wird nach dem Spritzgießen das Trägerelement auf Raumtemperatur, von z.B. 20°C abgekühlt, wobei bevor das Trägerelement 20°C erreicht hat, die Dämpfungsschicht auf das Trägerelement aufgebracht wird. Die Dämpfungsschicht wird somit im selben Spritzgussverfahren hergestellt wie das Trägerelement, sodass effizient die entsprechenden Komponenten hergestellt werden können. Insbesondere wird eine gute Haftverbindung zwischen der Dämpfungsschicht und dem Trägerelement erzeugt, wenn die Dämpfungsschicht vor der kompletten Ausfüllung und Aushärtung des Trägerelements auf dieses im Spritzgussverfahren aufgetragen wird.

Gemäß einer weiteren beispielhaften Ausführungsform verläuft der elektrische Leiter zum externen Anschluss von der elektronischen Komponente zu dem Trägerelement, wobei der elektrische Leiter mit der elektronischen Komponente mittels Lötens, Schweißens, Steckens insbesondere einer Schneidklemmverbindung und/ oder Klemmens elektronisch gekoppelt wird.

Mit der vorliegenden Erfindung wird insbesondere zwischen kaum kompatiblen Polymeren, wie beispielsweise der Füllmasse und dem Trägerelement, die aus thermoplastischen Material bestehende Dämpfungsschicht eingebracht, welche damit als Haftvermittler für die weniger kompatiblen Komponenten Füllmasse/Trägerelement dient.

Wenn die elektronische Komponente in Kavitäten eines Spritzgussteils als Trägerelement (z.B. bildet das Spritzgussteil einen Teil eines Außengehäuses) montiert wird und das Spritzgussteil faserverstärkt ist, wird das Spritzgussteil zu einem Leiter für mechanische Vibrationen. Dies beruht darauf, dass Fasern in ihrer Längsrichtung sehr steif sind und deshalb mechanische Vibrationen oder Schall sehr gut leiten. Durch die sehr hohe Anzahl von Fasern in einem faserverstärkten Kunststoff finden sich dadurch viele Wege zur Vibrationsausbreitung, insbesondere in Fliessrichtung des Kunststoffes beim Spritzgießvorgang, da dies einer Vorzugsausrichtung der Fasern nahekommt. Wenn nun die elektronische Komponente in eine derartige Spritzgusskomponente eingesetzt und mit einem Vergussmittel ausgegossen wird, kann ein doppeltes Resonanzsystem entstehen. Ein Übertragungskanal für Vibrationen kann sich durch die elektrischen Anschlüsse, insbesondere wenn diese aus Massivleitern bestehen, ergeben. Der zweite Übertragungskanal kann durch das faserverstärkte Spritzgussgehäuse gebildet werden, das via Vergussmasse ebenfalls auf die elektronische Komponente wirkt. Insbesondere glatte Oberflächen auf der Spritzgussteilinnenseite kann wie ein Lautsprecher eine Abstrahlfront für Vibrationen bilden, welche dann auf die elektronische Komponente wirkt. Dabei entsteht sowohl bei weichen (diese dämpfen die Schwingungen zwar besser, aber haben auch eine Eigenfrequenz) als auch bei harten Ausgestaltungen der Vergussmassen ein kritisches Resonanzfrequenzfenster, bei welchem sich auf diesem zweiten Kanal ein Resonanzsystem ausbildet. Da z.B. im Automotive-Bereich Vibrationen von 1 bis 10000 Hz in der ganzen Bandbreite vorkommen und durch die nicht sinusförmigen Vibrationen auch Frequenzanteile von der harmonischen Vielfachen enthalten sind, wird es immer wieder kurzzeitige Zustände dieser Resonanzbildung geben.

Durch die erfindungsgemäße Vibrationsreduktion über die Dämpfungsschicht kann so eine große Bandbreite von verschiedenen Fasermaterialien eingesetzt werden. Die hohen Festigkeiten (E-modul ab 3000 GPa, insbesondere 5000-12000 GPa, in besonderen Fällen bis 20.000 GPa) des Trägerelements können genutzt werden, da die erzielte Dämpfung mittels der Dämpfungsschicht die damit einhergehende Schwingungsneigung kompensiert. Insbesondere können so auch Langfasern verwendet werden, welche besondere konstruktive Vorteile erlauben (Langfasern orientieren sich noch deutlich mehr in Flussrichtung, insbesondere beim Einspritzvorgang der Spritzgussmaschine als die üblichen normale Fasern). Die erfindungsgemäße Verwendung von TPE als Dämpfungsschicht zur Schwingungsdämpfung dient zusätzlich als idealer Haftvermittler zwischen dem Trägerelement und einer Vergussmasse.

In einer weiteren besonders bevorzugten Ausführungsform wird durch die erfindungsgemäße Lösung eine Wasserdichtheit nach IP 67 erreicht. Dabei sind insbesondere die hohe Haftkraft zwischen Spritzgussteil und TPE, sowie zwischen TPE und Vergussmasse von besonderer Bedeutung.

Es wird darauf hingewiesen, dass Ausführungsformen der Erfindung mit Bezug auf unterschiedliche Erfindungsgegenstände beschrieben wurden.

Insbesondere sind einige Ausführungsformen der Erfindung mit Vorrichtungsansprüchen und andere Ausführungsformen der Erfindung mit Verfahrensansprüchen beschrieben. Dem Fachmann wird jedoch bei der Lektüre dieser Anmeldung sofort klar werden, dass, sofern nicht explizit anders angegeben, zusätzlich zu einer Kombination von Merkmalen, die zu einem Typ von Erfindungsgegenstand gehören, auch eine beliebige Kombination von Merkmalen möglich ist, die zu unterschiedlichen Typen von Erfindungsgegenständen gehören.

### Kurze Beschreibung der Zeichnungen

Im Folgenden werden zur weiteren Erläuterung und zum besseren Verständnis der vorliegenden Erfindung Ausführungsbeispiele unter Bezugnahme auf die beigefügten Zeichnungen näher beschrieben.
Fig. 1 zeigt eine schematische Darstellung einer Vorrichtung, in welcher eine Dämpfungsschicht einen elektrischen Leiter zwischen einer elektronischen Komponente und einem Trägerelement vollständig umgibt, gemäß einer beispielhaften Ausführungsform der vorliegenden Erfindung.
Fig. 2 zeigt eine schematische Darstellung einer Vorrichtung mit einer Dämpfungsschicht und einer Füllmasse gemäß einer beispielhaften Ausführungsform der vorliegenden Erfindung.
Fig. 3 zeigt eine schematische Darstellung einer Vorrichtung, in welcher ein elektrischer Leiter von einer elektronischen Komponente durch ein Trägerelement geführt wird, gemäß einer beispielhaften Ausführungsform der vorliegenden Erfindung.
Fig. 4 zeigt eine schematische Darstellung einer Vorrichtung, in welcher ein U-förmiges Trägerelement dargestellt wird, gemäß einer beispielhaften Ausführungsform der vorliegenden Erfindung.
Fig. 5 zeigt eine schematische Draufsicht einer Vorrichtung, in welcher das Trägerelement umfänglich eine elektronische Komponente umgibt, gemäß einer beispielhaften Ausführungsform der vorliegenden Erfindung.

### Detaillierte Beschreibung von exemplarischen Ausführungsformen

Gleiche oder ähnliche Komponenten in unterschiedlichen Figuren sind mit gleichen Bezugsziffern versehen. Die Darstellungen in den Figuren sind schematisch.

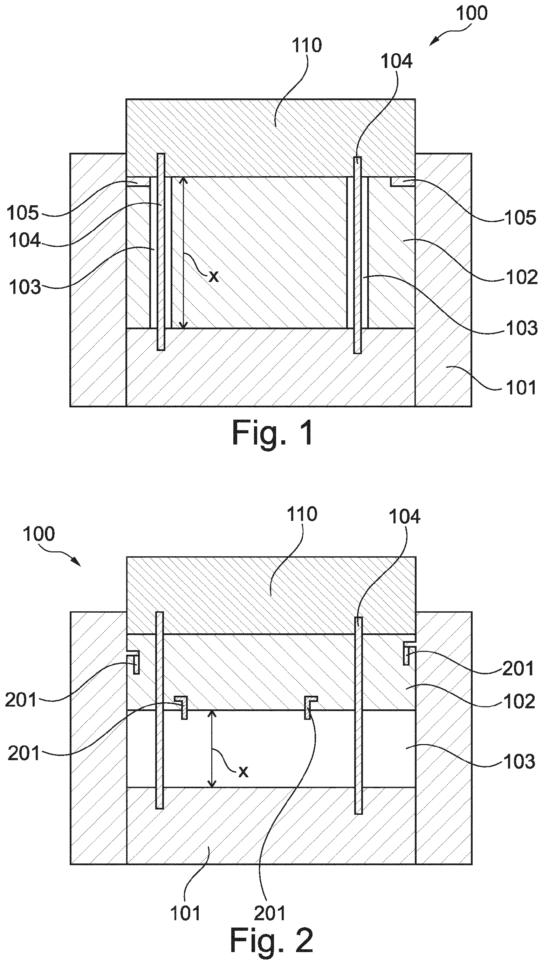

**Fig. 1** zeigt eine schematische Darstellung einer Vorrichtung 100, in welcher eine Dämpfungsschicht 103 einen elektrischen Leiter, insbesondere einen Massivleiter 104, zwischen einer elektronischen Komponente 110 und einem Trägerelement 101 vollständig umgibt.

Die Vorrichtung 100 ist zum vibrationssicheren Einhausen der elektronischen Komponente 110 vorgesehen. Die Vorrichtung 100 weist ein faserverstärktes, spritzgegossenes Trägerelement 101 auf, welches eine Kavität zum Aufnehmen der elektronischen Komponente 110 aufweist. Ferner weist die Vorrichtung 100 die elektronische Komponente 110, welche in der Kavität angeordnet ist, und eine Dämpfungsschicht 103, welche direkt auf dem Trägerelement 101 aufgebracht ist und zumindest bereichsweise zwischen der elektronischen Komponente 110 und dem Trägerelement 101 angeordnet ist auf, wobei die Dämpfungsschicht 103 ein Material aus thermoplastischem Elastomer aufweist und eine Dicke zwischen der elektronischen Komponente 110 und dem Trägerelement 101 von mindestens 100 µm aufweist. Die Vorrichtung weist ferner eine Füllmasse 102 auf, welche an der Dämpfungsschicht 103 und der elektronischen Komponente 110 anhaftet und zwischen der elektronischen Komponente 110 und dem Trägerelement 101 angeordnet ist, Zudem ist ein elektrischer Leiter vorgesehen, welcher mit der elektronischen Komponente 110 und dem Trägerelement 101 gekoppelt ist und zumindest bereichsweise von der Dämpfungsschicht 103 umgeben ist.

Die elektronische Komponente 110 in Fig. 1 stellt beispielsweise eine Mikroschalter dar. Die elektronische Komponenten 110 ist ferner an den elektrischen Leiter 104 gekoppelt, welcher zur Energieübertragung oder Signalübertragung insbesondere an die Umgebung dient. Die elektrischen Leiter 104 sind als Massivleiter ausgebildet. Die elektronische Komponente 110 ist in dem Trägerelement 101, welches als Spritzgussgehäuse ausgebildet ist, eingebettet. Insbesondere ist die elektronische Komponente 110 zur Kontaktierung mit den Massivleitern 104 ausgebildet, welche z.B. mit entsprechenden Leitern im Trägerelement 101 elektrisch leitend gekoppelt werden können.

Das Trägerelement 101 ist ein faserverstärktes, spritzgegossenes Bauteil, welches über eine ausreichende Festigkeit und Härte verfügt. Das Trägerelement 101 weist die Kavität auf, in welcher die elektronische Komponente 110 eingebettet ist. Das Trägerelement 101 und dessen Kavität können dabei derart ausgebildet sein, dass zumindest zwei Seiten einer elektronischen Komponente 110 abgedeckt werden können. So kann beispielsweise eine Kavität mittels eines V- förmigen oder L- förmigen Trägerelements 101 gebildet werden. In der beispielhaften Ausführungsform in Fig. 1 bildet das Trägerelement 101 eine U-Form aus, wobei die Bodenfläche und zumindest zwei Seitenflächen die Kavität bilden. Die elektronische Komponente 110 ragt aus der Oberseite hinaus.

Das Trägerelement 101 ist faserverstärkt, um eine hohe Festigkeit zu gewährleisten. Dabei können Faserverstärkungsmaterialien eingesetzt werden, die eingebettet in eine Polymermatrix einen Faserverbundstoff ergeben.

Die Füllmasse 102 fixiert zumindest teilweise die elektronische Komponente 110 und bildet eine Befestigung der elektronischen Komponente 110 in der Kavität des Trägerelements 101. In Fig. 1 legt die elektronische Komponente 110 mit ihrem Bodenbereich vollständig auf der Füllmasse 102 auf. Ein Volumen zwischen der elektronischen Komponente 110 und dem Bodenbereich des Trägerelements 101 wird nahezu vollständig mit der Füllmasse 102 ausgegossen, wobei in Dämpfungsbereichen die Dämpfungsschicht 103 auf dem Trägerelement 101 im Bodenbereich direkt aufgetragen ist und entlang des elektrischen Leiters 104 bis zur der elektronischen Komponente 110 verläuft.

Als Vergussmasse können insbesondere giessbare Kunststoffe auf PUR (Polyurethan) oder Epoxidbasis eingesetzt werden. Die Füllmasse 102 haftet an der elektronischen Komponente 110 an und ist zwischen der elektronischen Komponente 102 und dem Trägerelement 101 angeordnet, um die elektronische Komponente 110 entsprechend zu befestigen. Ferner ist die Füllmasse 102 zumindest in einem Teilbereich an der Dämpfungsschicht 103 anhaftend. Dadurch kann die Dämpfungsschicht 103 Vibrationen der insbesondere steiferen Füllmasse 102 aufnehmen.

Die Dämpfungsschicht 103 besteht aus einem thermoplastischen Elastomer (TPE). Die Dämpfungsschicht 103 verhält sich insbesondere bei Raumtemperatur vergleichbar mit klassischen Elastomeren. Unter Wärmezufuhr verformt sich die Dämpfungsschicht 103 plastisch und zeigt somit ein thermoplastisches Verhalten.

Die Dämpfungsschicht 103 ist ferner direkt auf dem Trägerelement 101 aufgebracht, sodass ebenfalls Vibrationen, welche von dem Trägerelement 101 auf die Dämpfungsschicht 103 übertragen werden, gedämpft werden können.

Der Bodenbereich des Trägerelements 101 ist gegenüberliegend zu der Öffnung der Kavität, durch welche die Komponente 110 hinausragt, angeordnet. In einem Dämpfungsbereich zwischen der elektronischen Komponente 110 und dem Bodenbereich des Trägerelements 101 beträgt die Dicke der Dämpfungsschicht 103 über 100 µm, wodurch gute Dämpfungseigenschaften bei gleichzeitiger vorteilhafter Haftung der Dämpfungsschicht bereitgestellt werden kann.

Insbesondere wird die Dicke der Dämpfungsschicht 103 entlang des kürzesten Abstands zwischen einem Bodenbereich oder Seitenbereich des Trägerelements 101, an welchem die Dämpfungsschicht 103 anhaftet, zur elektronischen Komponente 110 gemessen.

Der elektrische Leiter 104 ist zumindest bereichsweise von der Dämpfungsschicht 103 umgeben. In dem Dämpfungsbereich wie in Fig. 1 dargestellt, ist die Dämpfungsschicht 103 in direktem Kontakt mit dem Trägerelement 101 und der elektronischen Komponente 110. Mit anderen Worten wird in einen Volumenbereich zwischen der elektronischen Komponente 110 und dem Trägerelement 101 ein Dämpfungsbereich gebildet, in welchem die Dämpfungsschicht 103 direkt zwischen dem Trägerelement 101 und der elektronischen Komponente 110 verläuft. Der elektrische Leiter 104 läuft in der beispielhaften Ausführungsform zwischen dem Trägerelement 101 und der elektronischen Komponente 110 vollständig innerhalb der Dämpfungsschicht 103. Der elektrische Leiter 103 kann dabei in direkten Kontakt mit der Dämpfungsschicht stehen oder beabstandet, beispielsweise durch ein weiteres Trennmaterial, innerhalb der Dämpfungsschicht verlaufen.

Das E-Modul der Dämpfungsschicht 101 kann sich von dem E-Modul der Füllmasse 102 unterscheiden. Insbesondere ist das E-Modul der Dämpfungsschicht 103 kleiner als das E-Modul der Füllmasse 102. Insbesondere die unterschiedlichen E-Module zwischen der Dämpfungsschicht 103 und der Füllmasse 102 führen zu unterschiedlichen Eigenfrequenzen, wodurch wiederum die Dämpfungswirkung zwischen den beiden Materialkomponenten verstärkt wird.

Die Dämpfungsschicht 103 ist mittels einer stofflichen Verbindung an dem Trägerelement 101, der Füllmasse 102 und an der elektronischen Komponente 110 befestigt. Die Dämpfungsschicht 103, welche aus thermoplastischen Elastomeren, besteht, hat insbesondere bessere Hafteigenschaften als die Füllmasse 102, wie beispielsweise Kunstharz bzw. Epoxid.

Die Dämpfungsschicht 103 weist eine Kontaktfläche zu der Füllmasse 102 auf, welche strukturiert ausgebildet sein kann und insbesondere eine wellenförmige Oberfläche und/oder eine geriffelte Oberfläche aufweist.

Das Trägerelement 101 weist ferner Positionselemente 105 auf, an welchen die elektronische Komponente 110 anliegt und positionierbar ist. Das Positionselement 105 ist als Steg bzw. Stufe ausgebildet, um einen Sitz bzw. eine Auflage für die elektronische Komponente zu bilden. Das Positionselement 105 ist integral mit dem Trägerelement 101 ausgebildet und kann in einem gemeinsamen Spritzgussverfahren hergestellt werden.

**Fig. 2** zeigt eine schematische Darstellung einer Vorrichtung 100 mit einer Dämpfungsschicht 103 und einer Füllmasse 102 gemäß einer beispielhaften Ausführungsform der vorliegenden Erfindung.

Wie in dem Ausführungsbeispiel aus Fig. 1 verlaufen die elektrischen Leiter 104 zwischen der elektronischen Komponente 110 und einem Bodenbereich des Trägerelements 101. Die elektronische Komponente 110 ist in einer oberen Kavität des Trägerelements 101 angeordnet. Die Dämpfungsschicht 103 ist entlang des gesamten Bodenbereichs des Trägerelements 101 direkt anhaftend an dem Trägerelement 101 befestigt. Der Dämpfungsbereich erstreckt sich somit vollständig zwischen der elektronischen Komponente 110 und dem Trägerelement 101. Eine erste Oberfläche der Dämpfungsschicht 103 liegt direkt am Trägerelement 110 an. An der gegenüberliegenden zweiten Oberfläche der Dämpfungsschicht 103 liegt direkt die Füllmasse 102 an. Die Füllmasse 102 erstreckt sich von der zweiten Oberfläche bis zu der elektronischen Komponente 110. Der elektrische Leiter 104 verläuft zwischen dem Trägerelement 101 und der elektronischen Komponente 110 und entsprechend ausgehen von der elektronischen Komponente 110 zunächst durch die Füllmasse 102 und weiter durch die Dämpfungsschicht 103 zum Trägerelement 101.

Die Dämpfungsschicht 103 weist einen Vergussbügel 201 auf, insbesondere aufweisend eine Klammerform, welcher in die Füllmasse 102 ragt. Die Füllmasse 102 kann in einem Gießvorgang um den Vergussbügel 201 gegossen werden, sodass nach der Aushärtung eine gute mechanische Befestigung vorliegt.

Ein entsprechender Vergussbügel 201 kann ebenfalls von dem Trägerelement 101 in die Füllmasse 102 hineinragen und entsprechend eine mechanische Befestigung zwischen der Füllmasse 102 und dem Trägerelement 101 verbessern.

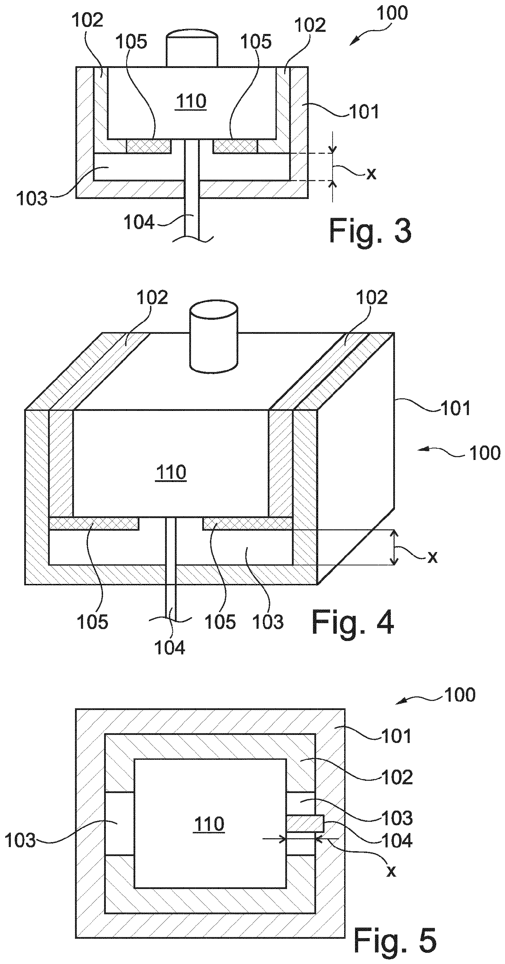

**Fig. 3** zeigt eine schematische Darstellung einer Vorrichtung 100, in welcher ein elektrischer Leiter 104 von einer elektronischen Komponente 110 durch ein Trägerelement 101 geführt wird. Die elektronische Komponente 110 ist in einer oberen Kavität des Trägerelements 101 angeordnet. Die Oberfläche eines Gehäuses der elektronischen Komponente 110 ist dabei bündig mit der oberen Kante des Trägerelements 101. Beispielsweise können funktionale Elemente der elektronischen Komponente 110, wie beispielsweise ein Schalterelement eines Mikroschalters, aus der Kavität des Trägerelements 101 hervorragen.

Zwischen einem Bodenbereich des Trägerelements 101, von welchem die entsprechenden Seitenwände hervorragen, um die Kavität zu bilden, und einer Unterseite der elektronischen Komponente 110 wird der Dämpfungsbereich mit der Dämpfungsschicht 103 gebildet. Die Dämpfungsschicht 103 ist beispielsweise entlang der gesamten Bodenfläche anhaftend am Trägerelement 101 befestigt. Die Dicke der Dämpfungsschicht 103 kann variieren, weist jedoch durchgehend im kleinsten Abstand x zwischen dem Trägerelement 101 und der elektronische Komponente 110 eine Dicke von mehr als 100 µm auf. In einem mittleren Bereich kontaktiert die Dämpfungsschicht 103 direkt die elektronische Komponente 110. In diesem mittleren Bereich verläuft ebenfalls ein elektrischer Leiter bzw. ein Massivleiter 104.

Der Massivleiter 104 kann dabei insbesondere durch den Bodenbereich des Trägerelements 101 nach außen geführt werden.

Zwischen dem seitlichen Bereich der elektronischen Komponente 110 und dem Trägerelement 101 liegt ein Bereich der Füllmasse 102 derart vor, dass ein Innenbereich der Vorrichtung 101 flüssigkeitsdichtend von einer Umgebung der Vorrichtung 100 abgedichtet ist. Somit wird in einem Abstandsbereich zwischen dem Trägerelement 101 und der elektronischen Komponente 110, in welchem Abstandsbereich eine Öffnung zur Umgebung vorliegt, das Abdichten mittels der Füllmasse 102 und/oder der Dämpfungsschicht 103 vorgesehen. Eine Füllung in diesem Abstandsbereich mit der Füllmasse 102 und/oder der Dämpfungsschicht 103 erhöht die Dichtwirkung.

Ferner können unter der Komponente 110 Positionselemente 105 vorgesehen werden, welche beispielsweise an dem Trägerelement 101 befestigt sind. Auf diesen Positionselementen 105 kann die elektronische Komponente 110 aufliegen und positioniert werden. Die Füllmasse 102 verfüllt die Seitenbereiche zwischen der elektronischen Komponente 110 und dem Trägerelement 101.

**Fig. 4** zeigt eine schematische Darstellung einer Vorrichtung, in welcher ein U-förmiges Trägerelement 101 dargestellt wird. Die Ausführungsform in Fig. 4 weist einen ähnlichen inneren Aufbau auf wie die Ausführungsform aus Fig. 3. Die Positionselemente 105 unter der elektronischen Komponente 110 sind an den seitlichen Randbereichen des Trägerelements 101 fixiert. Auf diesen Positionselementen 105 ist die elektronische Komponente 110 platziert und ausgerichtet. Der Massivleiter 104 verläuft von einer Unterseite der elektronischen Vorrichtung 110 durch den Bodenbereich des Trägerelements 101.

Das Trägerelement 101 als U-Form weist zwei gegenüberliegende Seitenwände auf, wobei dazwischen die Kavität, in welchen die elektronische Komponente 110 vorliegt, gebildet wird. Zwischen den Seitenwänden des Trägerelements 101 und den entsprechenden Seitenwänden der elektronischen Vorrichtung 102 ist die Füllmasse 102 vorgesehen. Der vordere Bereich und der hintere Bereich der elektronischen Komponente 110 sind dabei nicht von dem Trägerelement 101 abgedeckt. Somit ist von der entsprechenden Vorderseite und Rückseite die elektronische Komponente 110 zugänglich. Damit kann beispielsweise ein besserer Wärmetransport ermöglicht werden und gegebenenfalls Kühlkörper angekoppelt werden.

**Fig. 5** zeigt eine schematische Draufsicht einer Vorrichtung 100, in welcher das Trägerelement 101 umfänglich eine elektronische Komponente 110 umgibt. Das Trägerelement 101 weist somit vier Seitenwände auf, welche eine umlaufende geschlossene Kavität ausbilden. Das Trägerelement 101 bildet somit einen hohlen Würfel, wobei die oberen und z.B. die unteren Seiten offen sind und die elektronische Komponente 110 in das Innenvolumen eingebracht wird und ggf. eine der oberen oder unteren Seiten ergänzt.

Der seitliche Abstand zwischen der elektronischen Komponente 110 und dem Trägerelement 101 wird teilweise von der Füllmasse 102 ausgefüllt. Zusätzlich wird bereichsweise in diesen Seitenbereichen die Dämpfungsschicht 103 zum Bilden eines Dämpfungsbereichs eingefügt, welche insbesondere anhaftend an einer Seitenwand des Trägerelements 101 vorliegt. Durch einen Bereich der Dämpfungsschicht 103 wird der elektrische Leiter 104 geführt, welcher von der elektronischen Komponente 110 zu dem Trägerelement 101 führt. Die Dicke der Dämpfungsschicht 103 in dem kürzesten seitlichen Abstand x zwischen einer Seitenwand des Trägerelements 101 und der elektronischen Komponente 110 beträgt erfindungsgemäß über 100 µm.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können, solange sie den Gegenstand der unabhängigen Ansprüche erfüllen. Bezugszeichen in den Ansprüchen sind nicht als Einschränkung anzusehen.

### Bezuaszeichenliste:

100 Vorrichtung
101 Trägerelement
102 Füllmasse
103 Dämpfungsschicht
104 elektrischer Leiter/Massivleiter
105 Positionselement
110 elektronische Komponente
201 Vergussbügel
x maximale Dicke der Dämpfungsschicht

## Patentansprüche

1. Vorrichtung (100) zum vibrationssicheren Einhausen einer elektronischen Komponente (110), die Vorrichtung (100) aufweisend
ein faserverstärktes, spritzgegossenes Trägerelement (101), welches eine Kavität zum Aufnehmen der elektronischen Komponente (110) aufweist,
die elektronische Komponente (110), welche in der Kavität angeordnet ist,
eine Dämpfungsschicht (103), welche direkt auf dem Trägerelement (101) aufgebracht ist und zumindest bereichsweise zwischen der elektronischen Komponente (110) und dem Trägerelement (101) angeordnet ist,
wobei die Dämpfungsschicht (103) ein Material aus thermoplastischem Elastomer aufweist und eine Dicke zwischen der elektronischen Komponente (110) und dem Trägerelement (101) von mindestens 100 µm aufweist
eine Füllmasse (102), welche an der Dämpfungsschicht (103) und der elektronischen Komponente (110) anhaftet und zwischen der elektronischen Komponente (110) und dem Trägerelement (101) angeordnet ist,
einen elektrischen Leiter, welcher mit der elektronischen Komponente (110) und dem Trägerelement (101) gekoppelt ist und zumindest bereichsweise von der Dämpfungsschicht (103) umgeben ist.

2. Vorrichtung (100) gemäß Anspruch 1,
wobei die Füllmasse (102) zumindest bereichsweise in einem Dämpfungsbereich zwischen der Dämpfungsschicht (103) und der elektronischen Komponente (110) angeordnet ist, oder
wobei die Dämpfungsschicht (103) in einem Dämpfungsbereich in direktem Kontakt mit dem Trägerelement (101) und der elektronischen Komponente (110) ist.

3. Vorrichtung (100) gemäß Anspruch 1 oder 2,
wobei sich das E-Modul der Dämpfungsschicht (103) von dem E-Modul der Füllmasse (102) unterscheidet, und/oder
wobei die Dämpfungsschicht (103) zwischen der elektronischen Komponente (110) und dem Trägerelement (101) eine Dicke zwischen 0,5 mm und 5 mm aufweist, und/oder
wobei die Dämpfungsschicht (103) mittels einer stofflichen Verbindung an dem Trägerelement (101), der Füllmasse (102) und/oder an der elektronischen Komponente (110) befestigt ist.

4. Vorrichtung (100) gemäß einem der Ansprüche 1 bis 3,
wobei die Dämpfungsschicht (103) eine Kontaktfläche zu der Füllmasse (102) aufweist,
wobei die Kontaktfläche strukturiert ist und insbesondere eine wellenförmige Oberfläche und/oder eine geriffelte Oberfläche aufweist.

5. Vorrichtung (100) gemäß einem der Ansprüche 1 bis 4,
wobei die Kavität des Trägerelements (101) eine Öffnung aufweist, durch welche die elektronische Komponente (110) mit einem hervorragenden Bereich in die Umgebung ragt,
wobei zwischen dem hervorragenden Bereich und dem Trägerelement (101) zumindest ein Bereich der Dämpfungsschicht (103) und/oder des Füllmaterials derart vorliegt, dass ein Innenbereich der Vorrichtung (100) flüssigkeitsdichtend von einer Umgebung der Vorrichtung (100) abgedichtet ist.

6. Vorrichtung (100) gemäß einem der Ansprüche 1 bis 5,
wobei das Trägerelement (101) zumindest ein Positionselement (105) aufweist, an welchem die elektronische Komponente (110) anliegt und positionierbar ist,
wobei insbesondere das Positionselement (105) ein Führungszapfen, eine Führungsschiene oder eine Führungsbahn aufweist, an welchem ein korrespondierendes Koppelelement des elektronischen Bauteils koppelbar ist.

7. Vorrichtung (100) gemäß einem der Ansprüche 1 bis 6,
wobei das Trägerelement (101) Polypropylen und/oder Polybutylenterephthalat aufweist, und/oder
wobei das Trägerelement (101) einen Faseranteil in Gewichtsprozent zwischen 5% und 60%, insbesondere zwischen 10% und 50 %, und weiter insbesondere zwischen 15% und 40% aufweist.

8. Vorrichtung (100) gemäß einem der Ansprüche 1 bis 7,
wobei das Trägerelement (101) Verstärkungsfasern aufweist bestehend aus Mineralfasern, insbesondere Silikate, Glas, Basalt, Asbest, Wollastonit, Carbonfasern, insbesondere Kohlenstoffnanoröhren, Polymerfasern, insbesondere Polyamidfaser, Polyimidfasern, Polyester, Polyolefine, Polyesteramide, Aramide, insbesondere Kevlar und/oder Naturfasern, insbesondere Cellulose, Baumwolle, Viskose, Lyocell, Holz, Hanf, Seide,
wobei insbesondere die Verstärkungsfasern Langfasern mit einer Länge von 1 mm bis 20mm, insbesondere von 5mm bis 15 mm aufweisen.

9. Vorrichtung (100) gemäß einem der Ansprüche 1 bis 8,
wobei die Füllmasse (102) Polyurethan oder Epoxidharz aufweist.

10. Vorrichtung (100) gemäß einem der Ansprüche 1 bis 9,
wobei der elektrische Leiter ein Massivleiter (104) ist,
wobei der Massivleiter (104) insbesondere einen Querschnitt von 0,1mm² bis 10 mm² aufweist.

11. Vorrichtung (100) gemäß einem der Ansprüche 1 bis 10,
wobei der elektrische Leiter zum externen Anschluss von der elektronischen Komponente (110) durch das Trägerelement (101) verläuft,
wobei der elektrische Leiter mit der elektronischen Komponente (110) mittels Lötens, Schweißens, Steckens insbesondere einer Schneidklemmverbindung und/ oder Klemmens elektronisch gekoppelt ist.

12. Vorrichtung (100) gemäß einem der Ansprüche 1 bis 11,
wobei die elektronische Komponente (110) ein Mikroschalter, ein Aktor, ein Widerstand oder ein Sensor, insbesondere ein Temperatursensor oder ein Abstandsschalter ist.

13. Verfahren zum Herstellen einer Vorrichtung (100) nach einem der Ansprüche 1 bis 12.

14. Verfahren gemäß Anspruch 13,
wobei die Dämpfungsschicht (103) mittels eines Spritzgußverfahrens, insbesondere mittels eines 2-Komponenten Spritzgussverfahrens, auf das Trägerelement (101) aufgebracht wird,
wobei insbesondere nach dem Spritzgießen das Trägerelement (101) auf 20°C abgekühlt wird,
wobei insbesondere bevor das Trägerelement (101) 20°C erreicht hat, die Dämpfungsschicht (103) auf das Trägerelement (101) aufgebracht wird.

15. Verfahren gemäß einem Anspruch 13 oder 14,
wobei der elektrische Leiter zum externen Anschluss von der elektronischen Komponente (110) zu dem Trägerelement (101) verläuft,
wobei der elektrische Leiter mit der elektronischen Komponente (110) mittels Lötens, Schweißens, Steckens insbesondere einer Schneidklemmverbindung und/ oder Klemmens elektronisch gekoppelt wird.

## Claims

1. Device (100) for housing in a vibration-proof manner an electronic component (110), the device (100) comprising
a fiber-reinforced, injection-molded carrier element (101) which comprises a cavity for receiving the electronic component (110),
the electronic component (110) which is arranged in the cavity,
a damping layer (103) which is applied directly on the carrier element (101) and which is arranged at least in portions between the electronic component (110) and the carrier element (101),
wherein the damping layer (103) comprises a material made of a thermoplastic elastomer and a thickness between the electronic component (110) and the carrier element (101) of at least 100 µm,
a filling mass (102) which adheres to the damping layer (103) and the electronic component (110), and which is arranged between the electronic component (110) and the carrier element (101),
an electric conductor which is coupled with the electronic component (110) and the carrier element (101), and which is at least in portions surrounded by the damping layer (103).

2. Device (100) according to claim 1,
wherein the filling mass (102) is at least in portions arranged in a damping region between the damping layer (103) and the electronic component (110), or
wherein the damping layer (103) in a damping region is in direct contact with the carrier element (101) and the electronic component (110).

3. Device (100) according to claim 1 or 2,
wherein the elastic modulus of the damping layer (103) differs from the elastic modulus of the filling mass (102), and/or
wherein the damping layer (103) between the electronic component (110) and the carrier element (101) comprises a thickness between 0,5 mm and 5 mm, and/or
wherein the damping layer (103) is attached to the carrier element (101), the filling mass (102) and/or to the electronic component (110) by a material connection.

4. Device (100) according to one of the claims 1 to 3,
wherein the damping layer (103) comprises a contact surface to the filling mass (102),
wherein the contact surface is structured and in particular comprises a wave-shaped surface and/or a corrugated surface.

5. Device (100) according to one of the claims 1 to 4,
wherein the cavity of the carrier element (101) comprises an opening through which the electronic component (110) protrudes into the environment with a protruding region,
wherein between the protruding region and the carrier element (101) at least one region of the damping layer (103) and/or of the filling material is present, such that an inner region of the device (100) is sealed from an environment of the device (100) in a fluid-tight manner.

6. Device (100) according to one of the claims 1 to 5,
wherein the carrier element (101) comprises at least one positioning element (105), at which the electronic component (110) abuts and is positionable,
wherein in particular the positioning element (105) comprises a guiding pin, a guiding rail, or a guiding trace, at which a corresponding coupling element of the electronic component is couplable.

7. Device (100) according to one of the claims 1 to 6,
wherein the carrier element (101) comprises polypropylene and/or polybutylene terephthalate, and/or
wherein the carrier element (101) comprises a fiber portion in weight-percent between 5 % and 60 %, in particular between 10 % and 50 %, and further in particular between 15 % and 40 %.

8. Device (100) according to one of the claims 1 to 7,
wherein the carrier element (101) comprises reinforcing fibers, consisting of mineral fibers, in particular silicates, glass, basalt, asbestos, wollastonite, carbon fibers, in particular carbon nanotubes, polymer fibers, in particular polyamide fibers, polyimide fibers, polyester, polyolefins, polyester amide, aramid, in particular Kevlar and/or natural fibers, in particular cellulose, cotton, viscose, lyocell, wood, hemp, silk,
wherein in particular the reinforcing fibers comprise long fibers with a length of 1 mm to 20 mm, in particular of 5 mm to 15 mm.

9. Device (100) according to one of the claims 1 to 8,
wherein the filling mass (102) comprises polyurethane or epoxy resin.

10. Device (100) according to one of the claims 1 to 9,
wherein the electric conductor is a massive conductor (104),
wherein the massive conductor (104) in particular comprises a cross-section of 0,1 mm² to 10 mm².

11. Device (100) according to one of the claims 1 to 10,
wherein the electric conductor runs through the carrier element (101) for an external connection of the electronic component (110),
wherein the electric conductor is electrically coupled with the electronic component (110) by soldering, welding, plugging, in particular of an insulation displacement connection, and/or clamping.

12. Device (100) according to one of the claims 1 to 11,
wherein the electronic component (110) is a microswitch, an actuator, a resistance, or a sensor, in particular a temperature sensor or a distance sensor.

13. Method for manufacturing a device (100) according to one of the claims 1 to 12.

14. Method according to claim 13,
wherein the damping layer (103) is applied on the carrier element (101) by an injection molding method, in particular by a two-component injection molding method,
wherein in particular after the injection-molding, the carrier element (101) is cooled to 20°C,
wherein in particular before the carrier element (101) reaches 20°C, the damping layer (103) is applied on the carrier element (101).

15. Method according to one of the claims 13 or 14,
wherein the electric conductor for an external connection runs from the electronic component (110) to the carrier element (101),
wherein the electric conductor is electrically coupled with the electronic component (110) by soldering, welding, plugging, in particular of an insulation displacement connection, and/or clamping.

## Revendications

1. Dispositif (100) permettant d'héberger un composant électronique (110) en le protégeant contre les vibrations, le dispositif (100) comprenant
un élément porteur (101) renforcé de fibres et moulé par injection, qui présente une cavité permettant d'accueillir le composant électronique (110),
le composant électronique (110), qui est agencé dans la cavité,
une couche d'amortissement (103), qui est appliquée directement sur l'élément porteur (101) et qui est agencée au moins par endroits entre le composant électronique (110) et l'élément porteur (101),
dans lequel la couche d'amortissement (103) présente un matériau en élastomère thermoplastique et présente une épaisseur d'au moins 100 um entre le composant électronique (110) et l'élément porteur (101),
une masse de remplissage (102), qui adhère à la couche d'amortissement (103) et au composant électronique (110) et qui est agencée entre le composant électronique (110) et l'élément porteur (101),
un conducteur électrique qui est couplé au composant électronique (110) et à l'élément porteur (101) et qui est entouré au moins par endroits par la couche d'amortissement (103).

2. Dispositif (100) selon la revendication 1,
dans lequel la masse de remplissage (102) est agencée au moins par endroits dans une région d'amortissement entre la couche d'amortissement (103) et le composant électronique (110), ou
dans lequel la couche d'amortissement (103) est en contact direct avec l'élément porteur (101) et le composant électronique (110) dans une région d'amortissement.

3. Dispositif (100) selon la revendication 1 ou 2,
dans lequel le module E de la couche d'amortissement (103) est différent du module E de la masse de remplissage (102), et/ou
dans lequel la couche d'amortissement (103) présente une épaisseur comprise entre 0,5 mm et 5 mm entre le composant électronique (110) et l'élément porteur (101), et/ou
dans lequel la couche d'amortissement (103) est fixée à l'élément porteur (101), à la masse de remplissage (102) et/ou au composant électronique (110) au moyen d'une liaison matérielle.

4. Dispositif (100) selon l'une quelconque des revendications 1 à 3,
dans lequel la couche d'amortissement (103) présente une surface de contact avec la masse de remplissage (102),
dans lequel la surface de contact est structurée et présente en particulier une surface ondulée et/ou une surface rainurée.

5. Dispositif (100) selon l'une quelconque des revendications 1 à 4,
dans lequel la cavité de l'élément porteur (101) présente une ouverture à travers laquelle une région saillante du composant électronique (110) fait saillie dans l'environnement,
dans lequel au moins une région de la couche d'amortissement (103) et/ou du matériau de remplissage est présente entre la région saillante et l'élément porteur (101) de telle manière qu'une région intérieure du dispositif (100) est scellée de manière étanche aux fluides par rapport à un environnement du dispositif (100).

6. Dispositif (100) selon l'une quelconque des revendications 1 à 5,
dans lequel l'élément porteur (101) présente au moins un élément de positionnement (105) contre lequel le composant électronique (110) s'appuie et peut être positionné,
dans lequel l'élément de positionnement (105) présente en particulier une cheville de guidage, un rail de guidage ou une piste de guidage au niveau duquel ou de laquelle un élément de couplage correspondant du composant électronique (110) peut être couplé.

7. Dispositif (100) selon l'une quelconque des revendications 1 à 6,
dans lequel l'élément porteur (101) comprend du polypropylène et/ou du poly (téréphtalate de butylène), et/ou
dans lequel l'élément porteur (101) présente une teneur en fibres en pourcentage en poids comprise entre 5 % et 60 %, de manière particulièrement préférée comprise entre 10 % et 50 %, et de manière plus particulièrement préférée comprise entre 15 % et 40 %.

8. Dispositif (100) selon l'une quelconque des revendications 1 à 7,
dans lequel l'élément porteur (101) présente des fibres de renforcement constituées de fibres minérales, en particulier des silicates, du verre, du basalte, de l'amiante, de la wollastonite, de fibres de carbone, en particulier des nanotubes de carbone, de fibres polymères, en particulier des fibres de polyamide, des fibres de polyimide, du polyester, des polyoléfines, des polyesteramides, d'aramides, en particulier du kevlar, et/ou de fibres naturelles, en particulier de la cellulose, du coton, du viscose, du lyocell, du bois, du chanvre, de la soie,
dans lequel les fibres de renforcement présentent en particulier des fibres longues d'une longueur comprise entre 1 mm et 20 mm, en particulier comprise entre 5 mm et 15 mm.

9. Dispositif (100) selon la revendication 1 ou 8, dans lequel la masse de remplissage (102) comprend du polyuréthane ou une résine époxy.

10. Dispositif (100) selon l'une quelconque des revendications 1 à 9,
dans lequel le conducteur électrique est un conducteur solide (104),
dans lequel le conducteur solide (104) présente en particulier une section comprise entre 0,1 mm² et 10 mm²,

11. Dispositif (100) selon l'une quelconque des revendications 1 à 10,
dans lequel le conducteur électrique permettant un raccordement externe du composant électronique (110) s'étend à travers l'élément porteur (101),
dans lequel le conducteur électrique est couplé électroniquement au composant électronique (110) par brasage, par soudage, par enfichage, en particulier d'un connecteur autodénudant, et/ou par coincement.

12. Dispositif (100) selon l'une quelconque des revendications 1 à 11,
dans lequel le composant électronique (110) est un microrupteur, un actionneur, une résistance ou un capteur, en particulier un capteur de température ou un capteur de distance.

13. Procédé de fabrication d'un dispositif (100) selon l'une quelconque des revendications 1 à 12.

14. Procédé selon la revendication 13,
dans lequel la couche d'amortissement (103) est appliquée sur l'élément porteur (101) au moyen d'un procédé de moulage par injection, en particulier au moyen d'un procédé de moulage par injection à deux composants,
dans lequel l'élément porteur (101) est refroidi à 20°C en particulier après le moulage par injection,
dans lequel la couche d'amortissement (103) est appliquée sur l'élément porteur (101) en particulier avant que l'élément porteur (101) n'ait atteint 20°C.

15. Procédé selon la revendication 13 ou 14,
dans lequel le conducteur électrique permettant un raccordement externe du composant électronique (110) s'étend par rapport à l'élément porteur (101),
dans lequel le conducteur électrique est couplé électroniquement au composant électronique (110) par brasage, par soudage, par enfichage, en particulier d'un connecteur autodénudant, et/ou par coincement.
